# EUROPÄISCHE PATENTANMELDUNG

(11) **EP 0 669 682 A2**
(43) Veröffentlichungstag der Anmeldung: **30.08.1995**
(21) Anmeldenummer: 95101713.6
(22) Anmeldetag: 08.02.1995
(51) Int. Cl.: H01R 43/20

(54) **Zentriervorrichtung zum Ausrichten von Anschlussstielen**

(30) Priorität: 24.02.1994 DE 9403104 U
(71) Anmelder: SIEMENS AKTIENGESELLSCHAFT, 80333 München (DE)
(72) Erfinder: Moyaert, Werner, Ing., B-8490 Snellegem (BE); van Steenkiste, Philippe, Ing., B-8540 Deerlijk (BE)

(57) **Zusammenfassung**

Die Zentriervorrichtung ist mit stiftförmigen, in einer Reihe nebeneinander angeordneten Ausrichtelementen (4) versehen, die zur Ausrichtung von zur Steckrichtung schrägen Anschlußstielen (2), z. B.eines Steckverbinders, und zur Zentrierung auf Bohrungen (11) einer Leiterplatte (12) zwischen sich in einer geschlossenen Stellung Einsteck- und Ausrichtöffnungen (9, 10) bilden und nach dem Einstekken der ausgerichteten Anschlußstiele in die Leiterplatte um 90 in eine offene Kammstellung drehbar sind, so daß die Zentriervorrichtung seitlich abgezogen werden kann.

## Beschreibung

Die Erfindung betrifft eine Zentriervorichtung zum Ausrichten von in einer Vielzahl in zueinander parallelen Reihen an einem Körper, z.B. an einem Steckverbinder oder Leistenkörper eines Steckverbinders abstehenden Anschlußstielen, mit an einem Träger angeordneten Ausrichtelementen.

Steckverbinder, die auf einer Leiterplatte montiert werden, weisen im allgemeinen eine größere Anzahl von Anschlußstielen auf, die sich von dem Körper des Steckverbinders, z.B. von einer Feder-oder Messerleiste, in dichter Anordnung in parallel beabstandeten Reihen weg erstrecken und mit denen der Steckverbinder in metallisierte, ebenfalls in parallelen Reihen angeordnete Bohrungen der Leiterplatte eingesteckt wird. Beim Bestücken einer Leiterplatte mit derartigen Steckverbindern entstehen aber dann Probleme, wenn Anschlußstiele des Steckverbinders leicht verbogen sind, d.h. schräg zur Steckrichtung stehen, deshalb nicht mehr zu den Leiterplattenbohrungen zentriert sind und dadurch beim Versuch, den Steckverbinder in die Leiterplattenbohrungen einzustecken, auf der Oberfläche der Leiterplatte anstoßen. Dies führt schon bei Steckverbindern mit z.B. 30 Anschlüssen, insbesondere aber bei hochpoligen Steckverbindern mit z.B. 96 und mehr Anschlüssen und bei langen Anschlußstielen zu Schwierigkeiten und einer insgesamt zeitaufwendigen Bestückung. Wenn Leiterplatten mit derartigen Steckverbindern von Hand bestückt werden, muß der Monteur dann vor dem Einsteckvorgang z.B. mit einer Pinzette versuchen, die verbogenen Anschlußstiele gerade, d.h. zurück in die Steckrichtung, zu biegen, so daß alle Anschlußstiele wieder in Steckrichtung zentriert sind und in die entsprechenden Bohrungen der Leiterplatte passen. Aus der EP 0 126 563 B 1 ist bereits ein Werkzeug zum Ausrichten einer Vielzahl von Anschlüssen bekannt, das aus zwei in sich starren Kammelementen mit einer Vielzahl von parallel zueinander und voneinander beabstandeten Zähnen besteht, wobei die Zähne der beiden Kammelemente jeweils an entgegengesetzten Längsseiten durch eine Reihe von Kerben profiliert sind. Die beiden Kammelemente sind übereinanderliegend und relativ gegeneinander verschiebbar zwischen einer offenen und einer geschlossenen Stellung zusammengehalten, wobei in der offenen Stellung die Anschlüsse in dem Ausrichtwerkzeug aufgenommen werden können und durch Verschieben der Kammelemente gegeneinander in die geschlossene Stellung verbogene Anschlüsse ausgerichtet werden.

Der Erfindung liegt die Aufgabe zugrunde, eine Zentriervorrichtung zum Ausrichten einer Vielzahl von Anschlußstielen zu schaffen, die eine möglichst einfache Ausrichtung und Zentrierung verbogener Anschlüsse gewährleistet und leicht handhabbar ist.

Diese Aufgabe wird bei einer Zentriervorrichtung der eingangs genannten Art durch die im Anspruch 1 angegebenen Merkmale gelöst.

Bei einer derartigen Zentriervorrichtung sind die der Ausrichtung von Anschlußstielen dienenden Ausrichtelemente in bestimmter Weise ausgebildet und reihenartig nebeneinander angeordnet. Die wesentlichen Merkmale dieser Ausrichtelemente sind deren rechteckige Querschnittsgrundform mit konvexen Schmalseiten, die Ausbildung mit Einsteck-und Ausrichtöffnungen an diesen Schmalseiten und die Drehbarkeit um 900, wodurch die Ausrichtelemente von einem zur Einführung und Ausrichtung der Anschlußstiele geschlossenen Zustand mit aneinanderliegenden oder nahezu aneinanderliegenden Schmalseiten in eine offene Kammstellung drehbar sind. Mit einer derartigen Zentriervorrichtung ist es möglich, verbogene, d.h. schräg zur Steckrichtung stehende Anschlußstiele vor dem Einstecken in Leiterplattenbohrungen auf einfache Weise auszurichten, d.h. auf die Leiterplattenbohrungen zu zentrieren und im in der Zentriervorrichtung steckenden ausgerichteten, zentrierten Zustand in die Leiterplattenbohrungen einzustekken. Wenn die Ausrichtelemente um 90 gedreht werden, entsteht aufgrund der Querschnittsform der Ausrichtelemente ein mindestens der lichten Außenweite der Anschlußstiele entsprechender Zwischenraum zwischen den einzelnen gedrehten Ausrichtelementen, der es ermöglicht, die Zentriervorrichtung von den ausgerichteten und in den Leiterplattenbohrungen steckenden Anschlußstielen abzuziehen. Danach kann der die Anschlußstiele aufweisende Körper, z.B. ein Steckverbinder oder ein Leistenkörper einer Feder- oder Messerleiste eines Steckverbinders, vollständig in die Leiterplatte eingesteckt werden. Mit der erfindungsgemäßen Zentriervorrichtung wird bereits durch das Einstecken der Anschlußstiele in die Ausrichtelemente eine einfache Ausrichtung und Zentrierung der Anschlußstiele erreicht, so daß eine Bestückung einer Leiterplatte mit einem Steckverbinder, dessen Anschlußstiele zunächst schräg zur Steckrichtung stehen, auch bei längeren Anschlußstielen und hochpoligen Steckverbindern ohne Schwierigkeiten, bei geringstmöglichem Zeitaufwand und mit einer leicht handhabbaren Zentriervorrichtung durchführbar ist.

Vorteilhafte Ausgestaltungen des Gegenstandes des Anspruchs 1 sind in den Unteransprüchen angegeben.

Die erfindungsgemäße Zentriervorrichtung und ihre Wirkungsweise ist im folgenden anhand eines in der Zeichnung dargestellten Ausführungsbeispiels näher erläutert. Es zeigen
Fig. 1 die Zentriervorrichtung in Draufsicht,
Fig. 2 eine Ansicht auf die Rückseite der Zentriervorrichtung,
Fig.3 eine Seitenansicht der Zentriervorrichtung im Schnitt,
Fig. 4 in perspektivischer, vergrößerter Darstellung einen Teil einer Reihe von Ausrichtelementen in geschlossener Stellung,
Fig. 5 einen Körper mit Anschlußstielen in Seitenansicht,
Fig. 6 eine Draufsicht auf in einem Raster angeordnete verbogene Anschlußstiele,
Fig. 7 die Bestückung einer Leiterplatte mit einem Anschlußstiele tragenden Körper in geschlossener Stellung der Zentriervorrichtung,
Fig. 8 die Bestückung einer Leiterplatte mit einem Anschlußstiele tragenden Körper in offener Kammstellung der Zentriervorrichtung,
Fig. 9 eine Draufsicht auf einen Teil der Zentriervorrichtung in offener Kammstellung und
Fig. 10 bis 14 in Teilansichten die einzelnen Phasen des Ausricht-, Zentrier- und Bestükkungsvorganges zur Bestückung einer Leiterplatte mit einem Anschlußstiele aufweisenden Körper.

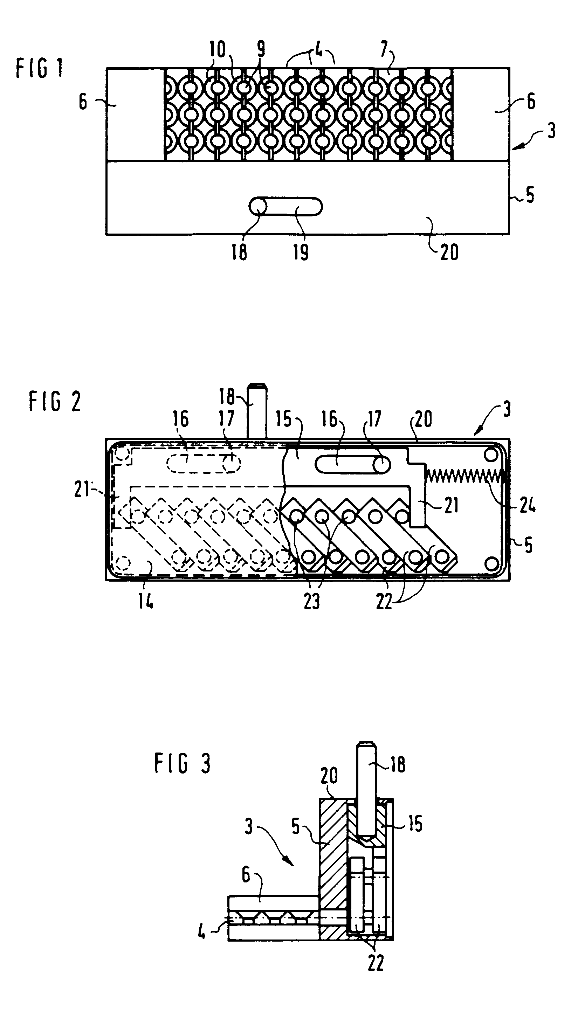

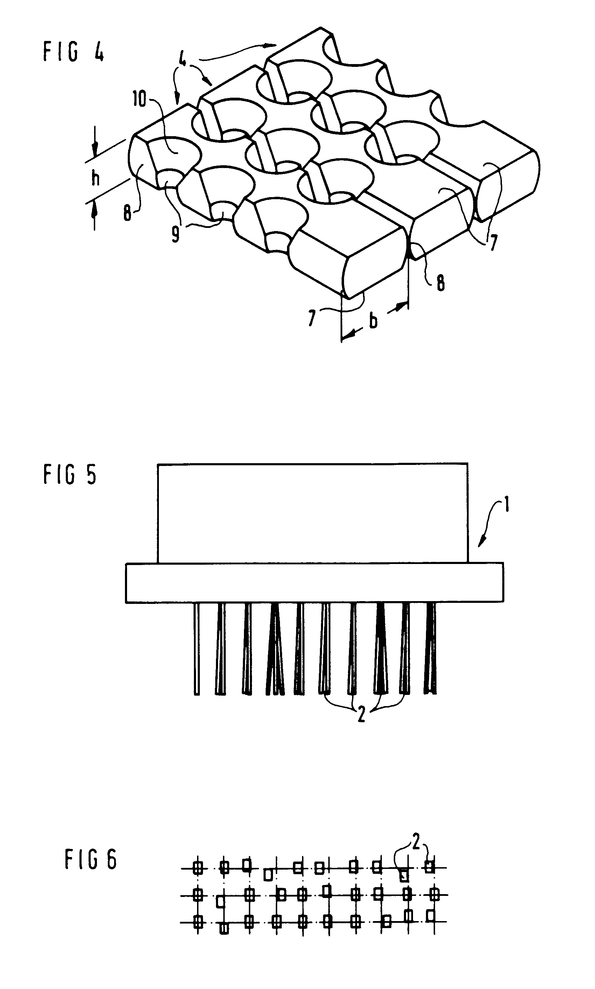

Die Zentriervorrichtung nach Fig. 1 dient zum Ausrichten von in einer Vielzahl in zueinander parallelen Reihen an einem Körper, z.B. an einem Steckverbinder oder einem Leistenkörper 1 (Fig.5), z.B. einer Feder- oder Messerleiste eines Steckverbinders abstehenden Anschlußstielen 2. Hierbei kann es sich z.B. um eine 30-polige Ausführung mit drei zueinander parallelen Reihen von jeweils zehn Anschlußstielen handeln, wobei - wie die Fig. 5 und 6 zeigen - die in einem bestimmten Raster angeordneten Anschlußstiele leicht verbogen sind, d.h. schräg zur späteren Steckrichtung des Steckverbinders stehen, so daß die im Querschnitt rechteckigen oder quadratischen Anschlußstiele in der Draufsicht nach Fig. 6 gesehen eine etwas exzentrische Lage in Bezug auf die Rasterpunkte einnehmen. Ein Steckverbinder mit derart verbogenen, nicht mehr zu den Einsteckbohrungen einer Leiterplatte ausgerichteten und zentrierten Anschlußstielen bereitet bei der Bestückung einer Leiterplatte Schwierigkeiten, so daß es erforderlich ist, vor dem Bestückungsvorgang die verbogenen Anschlußstiele 2 erst auszurichten und auf die Leiterplattenbohrungen zu zentrieren. Hierzu besteht die Zentriervorrichtung nach Fig. 1 im wesentlichen aus einem Träger 3 für eine Vielzahl von einzelnen, in bestimmter Weise ausgebildeten und angeordneten Ausrichtelementen 4. Der Träger 3 umfaßt einen quaderförmigenn Lagerbock 5, an dessen Vorderseite die Ausrichtelemente 4 zusammen mit zwei Seitenarmen 6 und zwischen diesen angeordnet im rechten Winkel zu dem Lagerbock abstehen. Die Ausrichtelemente 4 sind von Stiften mit einer im Querschnitt rechtekkigen Grundform gebildet (Fig.4), wobei die Differenz zwischen der längeren Breitseite 7 und der kürzen Schmalseite 8 der Ausrichtelemente mindestens der lichten Außenweite der Anschlußstiele 2 ist. Beispielsweise ist die Breite b der längeren Breitseite 7 der Ausrichtelemente 4 mit 2,54 mm, gewählt, während die Höhe h der kürzeren Schmalseite 8 der Ausrichtelemente etwa gleich 1,5 mm ist. Die Ausrichtelemente 4 sind an der kürzeren Schmalseite 8 jeweils konvex geformt und in einem zur Einführung und Ausrichtung der Anschlußstiele 2 geschlossenen Zustand der Zentriervorrichtung mit den einander zugekehrten konvexen Schmalseiten 8 aneinanderliegend oder nahezu aneinanderliegend nebeneinander in einer Reihe angeordnet (Fig.1,4 und 7). Wie insbesondere aus den Figuren 1 und 4 deutlich zu erkennen ist, sind die Schmalseiten 8 der Ausrichtelemente 4 an einander gegenüberliegenden Stellen mit durchgehenden Aussparungen 9 versehen, die an der gleichen (oberen) Breitseite 7 der im geschlossenen Zustand befindlichen Ausrichtelemente jeweils mit einem sich nach außen erweiternden Einführtrichter 10 ausgebildet sind. Diese Aussparungen 9 bilden im geschlossenen Zustand jeweils zusammen mit den Aussparungen 9 der gegenüberliegenden Schmalseite 8 eines benachbarten Ausrichtelementes 4 im Querschnitt runde oder rechteckige Einsteck- und Ausrichtöffnungen für die Anschlußstiele 2, wobei - wie die Fig.1 deutlich zeigt - die Einsteck- und Ausrichtöffnungen der im Ausführungsbeispiel insgesamt 11 nebeneinanderliegenden Ausrichtelemente in einem durch die Anzahl und Anordnung der Anschlußstiele vorgegebenen Raster, z.B. in einem quadratischen Raster mit einem Rasterabstand von 2,54 mm angeordnet sind.

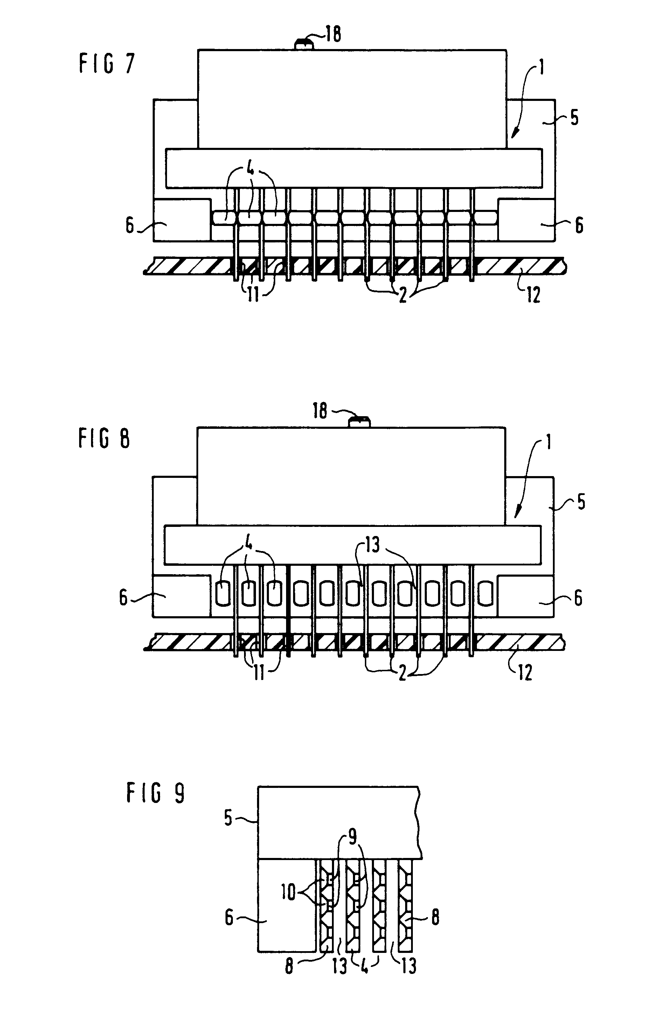

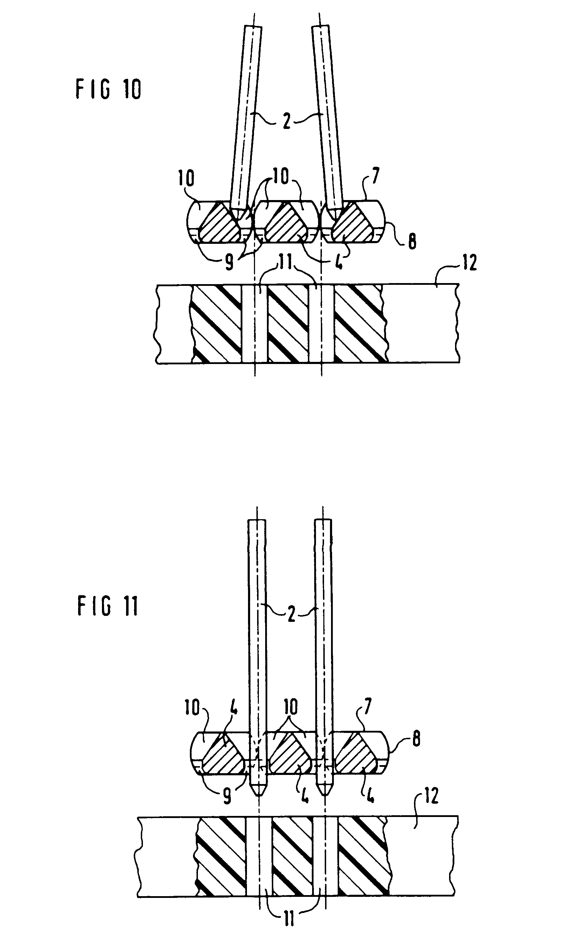

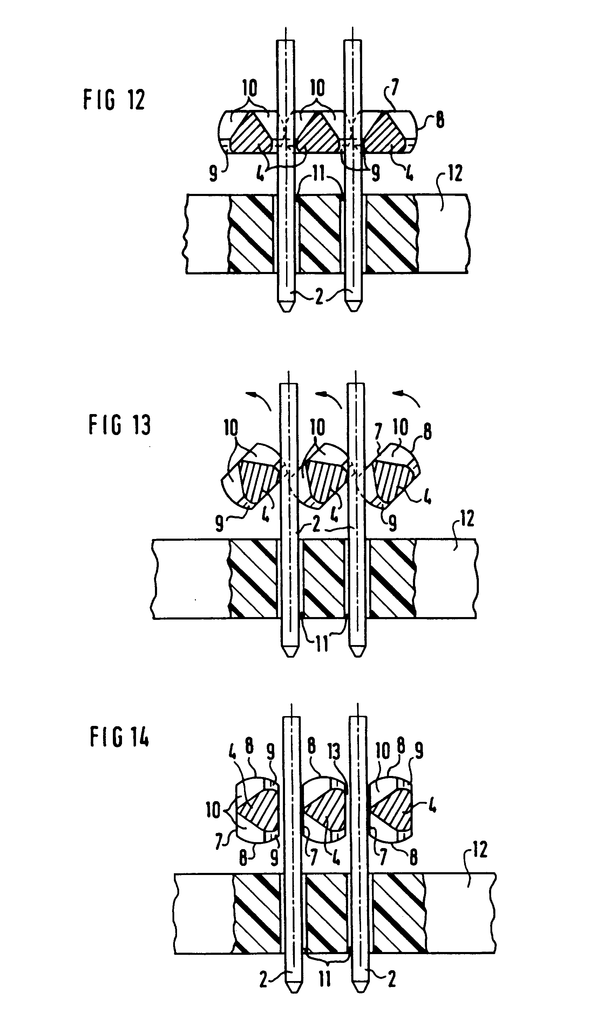

Zur Ausrichtung schräg zur Steckrichtung verbogener Anschlußstiele 2 auf im Raster der Anschlußstiele angeordnete Bohrungen 11 einer Leiterplatte 12 wird nun der Leistenkörper 5 mit seinen Anschlußstielen 2 einfach von oben - bei der Zentriervorrichtung in Fig.1 also senkrecht zur Zeichenebene - in die in den Figuren 1,4 und 7 in geschlossenem Zustand befindlichen Ausrichtelemente 4 der Zentriervorrichtung eingesteckt. Dabei laufen die freien Enden der schrägen und nicht auf die Bohrungen 11 der Leiterplatte 12 zentrierten Anschlußstiele 2 auf die Wandung der sie aufnehmenden, wesentlich größeren Einführtrichter 10 auf (Fig.10), wobei schräge Anschlußstiele beim weiteren Einstecken durch die sich nach innen verengenden Einführtrichter 10 in Richtung zur Mittelachse der Aussparungen 9 gebogen werden, so daß sich alle Anschlußstiele im in die Ausrichtelemente 4 eingesteckten Zustand (Fig.11) wieder genau im Raster befinden und deshalb in Bezug auf die im gleichen Raster angeordneten Bohrungen 11 der Leiterplatte 12 ausgerichtet und zentriert sind. Sodann können der Leistenkörper 5 bzw. seine Anschlußstiele 2 ohne Schwierigkeiten und ohne Aufstoßen der Enden der Anschlußstiele an der Leiterplattenoberfläche in Bohrungen 11 der Leiterplatte 12 eingesteckt werden (Fig.12), wobei die Zentriervorrichtung bzw. deren Ausrichtelemente 4 eine Führung für die Anschlußstiele bilden und die Zentriervorrichtung noch an den Anschlußstielen verbleibt (Fig. 7).

Bevor nun die schon in den Bohrungen 11 der Leiterplatte 12 steckenden Anschlußstiele 2 weiter in die Bohrungen eingeschoben werden können und der Steckverbinder in seine endgültige Position auf der Leiterplatte gebracht werden kann, muß die Zentriervorrichtung entfernt werden. Dies ist erst möglich,wenn die noch in den Aussparungen 9 der im geschlossenen Zustand befindlichen Ausrichtelemente 4 steckenden Anschlußstiele 2 von den Ausrichtelementen freigegeben werden. Hierzu sind die Ausrichtelemente 4 wie Achsen drehbar an dem Lagerbock 5 gelagert und zwar so, daß sie von dem geschlossenen Zustand (Fig.7) gemeinsam um 90 in eine offene Kammstellung drehbar sind. Der Beginn dieser Drehphase ist in Fig. 13 verdeutlicht, wobei zu erkennen ist, daß die Ausrichtelemente 4 gemeinsam entgegen dem Uhrzeigersinn gedreht werden, bis sie mit ihren Breitseiten 7 parallel zueinander stehen (Fig.14) und ein Zwischenraum 13 zwischen den einzelnen Ausrichtelementen gebildet ist. Die Breite dieses Zwischenraumes 13 ist von der Differenz zwischen der Breite b und der Höhe h der Ausrichtelemente 4 abhängig und jedenfalls mindestens so groß wie die lichte Außenweite der Anschlußstiele 2. Wie Fig.14 zeigt, ist der Zwischenraum 13 hier etwas größer als die Anschlußstiele und bei dem oben angegebenen Zahlenbeispiel für b = 2,54 mm und h = 1,5 mm etwa 1 mm breit. Aufgrund des nunmehr vorhandenen Zwischenraumes nehmen die Ausrichtelemente 4 jetzt in dem in den Fig. 8,9 gezeigten Zustand eine offene Kammstellung ein, so daß die Anschlußstiele 2 in dem aus der Leiterplatte herausragenden Bereich von den Ausrichtelementen 4 freigegeben werden und die Zentriervorrichtung seitlich abgezogen werden kann. Abschließend laßt sich der Steckverbinder dann in die endgültige Position in die Leiterplatte 12 eindrükken.

Um bei der erfindungsgemäßen Zentriervorrichtung die 90_{°}-Drehung der Ausrichtelemente 4 von deren geschlossenem Zustand in die offene Kammstellung durchführen zu können, sind die Ausrichtelemente 4 in geeigneter Weise an dem Lagerbock 5 gelagert und miteinander gekuppelt. Der hier aus einem Metallteil bestehende Lagerbock 5 ist zur Aufnahme der Lagerung und der Betätigungsmittel für die 90_{°}-Drehung der Ausrichtelemente 4 innen hohl (Fig.2) und an seiner mit einer Abdeckplatte 14 verschließbaren Rückseite zugänglich. Die Betätigungsmittel sind von außen bedienbar im Lagerbock 5 angeordnet und umfassen einen kulissenartig im Lagerbock geführten Schieber 15 z.B. aus Metall, der mit zwei senkrecht zur Steckrichtung verlaufenden langlochähnlichen Nuten 16 ausgebildet und in Stiften 17 des Lagerbockes geführt ist. Das Betätigungselement 18 für den Schieber 15 ist stiftförmig ausgebildet und ragt in einer langlochähnlichen Nut 19 an der Oberseite 20 des Lagerbockes geführt nach außen. Der Schieber 15 steht über zwei Seitenstege 21 mit den sich mit ihren Enden in das Innere des Lagerbockes 5 erstreckenden Ausrichtelementen 4 in Eingriff, welche hierzu mit entsprechenden Mitnehmerorganen ausgebildet sind. Diese bestehen jeweils aus einem am Ende eines jeden Ausrichtelementes senkrecht zu dessen Längsachse abstehenden Kupplungshebel 22 z.B. aus Metall mit einem Kupplungsstift 23 und sind so angeordnet, daß die Ausrichtelemente 4 bei Drehung miteinander gekuppelt sind. Eine Mitnehmerkupplung ist in diesem Fall z.B. so gebildet, daß die Kupplungshebel 22 der hier 11 Ausrichtelemente 4 in mindestens zwei Reihen hintereinander und gegeneinander versetzt angeordnet sind, so daß die Kupplungsstifte 23 der Kupplungshebel 22 der hinteren Hebelreihe die jeweils davor angeordnete Hebelreihe bei Drehung mitnehmen, indem die Kupplungsstifte 23 der versetzten hinteren Hebelreihe in die Zwischenräume der vorderen Hebelreihe ragen. Damit lassen sich die Mitnehmerorgane der Ausrichtelemente 4 über die Seitenstege 21 des Schiebers 15 von einer Endstellung in die andere Endstellung (Fig.2) bewegen, wobei die wie Achsen im Lagerbock gelagerten Ausrichtelemente 4 jeweils um 90 gedreht werden. Zweckmäßigerweise sind die Ausrichtelemente 4 in der geschlossenen Stellung (Fig.2,7) durch Federkraft gehalten, wobei die Federkraft z.B. von einer Druckfeder 24 erzeugt wird, welche auf den Schieber 15 einwirkt und hier zwischen dem einen Seitensteg 21 des Schiebers und einer Innenwand des Lagerbockes 5 abgestützt ist.

Bei dem dargestellten Ausführungsbeispiel ist die Zentriervorrichtung mit elf Ausrichtelementen ausgebildet und somit in ihrer Größe bei jeweils drei Einsteck- und Ausrichtöffnungen zwischen jeweils zwei Ausrichtelementen genau für einen 30- poligen Steckverbinder ausgelegt. Es ist jedoch auch möglich, die Zentriervorrichtung so auszulegen, daß sie nicht nur für Steckverbinder mit einer bestimmten Anzahl von Anschlüssen verwendbar ist. In diesem Fall ist die Zentriervorrichtung dann mit einer größeren Anzahl von Ausrichtelementen und/oder Einsteck- und Ausrichtöffnungen zwischen jeweils zwei Ausrichtelementen auszulegen. So kann eine Zentriervorrichtung mit z.B. 41 Ausrichtelementen und jeweils vier Einsteck- und Ausrichtöffnungen zwischen jeweils zwei Ausrichtelementen für die Ausrichtung von 4 x 40 Anschlußstielen, also für einen 160-poligen Steckverbinder, aber auch für Steckverbinder kleinerer Polzahl, z.B. für 30-polige Steckverbinder, verwendet werden. Es ist somit bei der erfindungsgemäßen Zentriervorrichtung nicht unbedingt erforderlich, unterschiedliche Größen vorrätig zu halten.

### Bezugszeichenliste

1 Leistenkörper
2 Anschlußstiele
3 Träger
4 Ausrichtelemente
5 Lagerbock
6 Seitenarme
7 Breitseite
8 Schmalseite
9 Aussparungen
10 Einführtrichter
11 Bohrungen
12 Leiterplatte
13 Zwischenraum
14 Abdeckplatte
15 Schieber
16,19 Nuten
17 Stifte
18 Betätigungselement
20 Oberseite des Lagerbockes
21 Seitenstege
22 Kupplungshebel
23 Kupplungsstifte
24 Druckfeder

## Patentansprüche

1. Zentriervorrichtung zum Ausrichten von in einer Vielzahl in zueinander parallelen Reihen an einem Körper, z.B. an einem Steckverbinder oder Leistenkörper (1) eines Steckverbinders abstehenden Anschlußstielen (2), mit an einem Träger (3) angeordneten Ausrichtelementen (4),
gekennzeichnet durch folgende Merkmale:
a) die Ausrichtelemente (4) sind von Stiften mit einer im Querschnitt rechteckigen Grundform gebildet,
b) die Differenz zwischen der längeren Breitseite (7) und der kürzeren Schmalseite (8) der Ausrichtelemente (4) entspricht mindestens der lichten Außenweite der Anschlußstiele (2),
c) die Ausrichtelemente (4) sind an der kürzeren Schmalseite (8) konvex geformt und in einem zur Einführung und Ausrichtung der Anschlußstiele (2) geschlossenen Zustand mit den einander zugekehrten konvexen Schmalseiten (8) aneinanderliegend oder nahezu aneinanderliegend nebeneinander in einer Reihe angeordnet,
d) die Schmalseiten (8) der Ausrichtelemente (4) sind an einander gegenüberliegenden Stellen mit durchgehenden Aussparungen (9) versehen, die an der gleichen Breitseite (7) der im geschlossenen Zustand befindlichen Ausrichtelemente (4) jeweils mit einem sich nach außen erweiternden Einführtrichter (10) ausgebildet sind und im geschlossenen Zustand zusammen mit den Aussparungen (9) der gegenüberliegenden Schmalseite (8) eines benachbarten Ausrichtelementes(4) Einsteck- und Ausrichtöffnungen für die Anschußstiele (2) bilden,
e) die Einsteck- und Ausrichtöffnungen sind in einem durch die Anzahl und Anordnung der Anschlußstiele (2) vorgegebenen Raster angeordnet,
f) die Ausrichtelemente (4) sind derart an dem Träger (3) gelagert, daß sie von dem geschlossenen Zustand gemeinsam um 90 in eine offene Kammstellung drehbar sind, so daß in dieser ein Zwischenraum (13) zwischen den Ausrichtelementen (4) gebildet ist.

2. Zentriervorrichtung nach Anspruch 1,
dadurch gekennzeichnet, daß der Träger (3) für die Ausrichtelemente (4) aus einen quaderförmigen Lagerbock (5) umfaßt und die Ausrichtelemente (4) an einer Vorderseite des Lagerbockes (5) im rechten Winkel zu dem Lagerbock abstehen.

3. Zentriervorrichtung nach Anspruch 2,
dadurch gekennzeichnet, daß der Lagerbock (5) zur Aufnahme der Lagerung der Ausrichtelemente (4) und von Betätigungsmitteln für die 90_{°}-Drehung innen hohl und an seiner Rückseite zugänglich ist.

4. Zentriervorrichtung nach Anspruch 3,
dadurch gekennzeichnet, daß die Betätigungsmittel von außen bedienbar im Lagerbock (5) angeordnet sind und einen kulissenartig im Lagerbock geführten Schieber (15) umfassen, der mit Mitnehmerorganen (22,23) der sich in das Innere des Lagerbockes (5) erstrekkenden Ausrichtelemente (4) in Eingriff steht.

5. Zentriervorrichtung nach Anspruch 4,
dadurch gekennzeichnet, daß die Mitnehmerorgane (22,23) der Ausrichtelemente (4) aus einem am Ende der Ausrichtelemente senkrecht abstehenden Kupplungshebel (22) mit einem Kupplungsstift (23) bestehen und so angeordnet sind, daß die Ausrichtelemente (4) bei Drehung miteinander gekuppelt sind.

6. Zentriervorrichtung nach Anspruch 5,
dadurch gekennzeichhet, daß die Kupplungshebel (22) der Ausrichtelemente (4) in mindestens zwei Reihen hintereinander und gegeneinander versetzt angeordnet sind, sodaß die Kupplungsstifte (23) der Kupplungshebel (22) der einen Hebelreihe die jeweils davor angeordnete Hebelreihe bei Drehung mitnehmen.

7. Zentriervorrichtung nach einem der vorhergehenden Ansprüche, dadurch gekennzeichnet, daß die Ausrichtelemente (4) in der geschlossenen Stellung durch Federkraft gehalten sind.

8. Zentriervorrichtung nach Anspruch 7,
dadurch gekennzeichnet, daß die Federkraft auf den Schieber (15) einwirkt.

9. Zentriervorrichtung nach einem der Ansprüche 4 bis 8,
dadurch gekennzeichnet, daß der Schieber (15) mit senkrecht zur Steckrichtung verlaufenden langlochähnlichen Nuten (16) ausgebildet und in Stiften (17) des Lagerbockes (5) geführt ist.

10. Zentriervorrichtung nach einem der Ansprüche 4 bis 9,
dadurch gekennzeichnet, daß das Betätigungselement (18) für den Schieber (15) stiftförmig ausgebildet ist.

11. Zentriervorrichtung nach einem der vorhergehenden Ansprüche, dadurch gekennzeichnet, daß die Breite (b) der längeren Breitseite (7) der Ausrichtelemente (4) gleich 2,54 mm und die Höhe (h) der kürzeren Schmalseite (8) der Ausrichtelemente (4) etwa gleich 1,5 mm ist, so daß sich bei in die offene Kammstellung gedrehten Ausrichtelementen (4) ein Zwischenraum (13) von etwa 1 mm zwischen den Ausrichtelementen (4) ergibt.

12. Zentriervorrichtung nach einem der vorhergehenden Ansprüche, dadurch gekennzeichnet, daß zumindest der Träger (3), die Ausrichtelemente (4), der Schieber (15) und die Kupplungshebel (22) aus Metall bestehen.
